# EUROPEAN PATENT APPLICATION

(11) **EP 4 418 472 A1**
(43) Date of publication of application: **21.08.2024**
(21) Application number: 22890025.4
(22) Date of filing: 04.11.2022
(51) Int. Cl.: H01S 3/042, H01S 3/08

(54) **OPTICAL ELEMENT, LASER DEVICE AND METHOD FOR MANUFACTURING OPTICAL ELEMENT**

(30) Priority: 04.11.2021 JP 2021180007
(71) Applicant: Inter-University Research Institute Corporation National Institutes of Natural Sciences, Tokyo 181-8588 (JP)
(72) Inventor: TAIRA, Takunori, Okazaki-shi, Aichi 444-8585 (JP); KAUSAS, Arvydas, Okazaki-shi, Aichi 444-8585 (JP); YOSHIDA, Mitsuhiro, Okazaki-shi, Aichi 444-8585 (JP)
(74) Representative: Ribeiro, James Michael
(86) International application number: PCT/JP2022/041208
(87) International publication number: WO 2023/080205

(57) **Abstract**

An optical element according to an embodiment includes a laser medium; a first intermediate layer provided on the laser medium; a first metal layer formed on the first intermediate layer and including a Group 4 element or a Group 6 element; and a heat sink provided on the first metal layer and including a metal, in which the first intermediate layer includes a dielectric multilayer film that is formed on the laser medium and totally reflects laser light generated or amplified by the laser medium, and the first intermediate layer is thicker than a protrusion length of an evanescent wave generated by reflection of light incident from the laser medium side by the dielectric multilayer film.

## Description

### Technical Field

The present invention relates to an optical element, a laser system, and a method for manufacturing an optical element.

### Background Art

As techniques of an optical element including a laser medium and a laser system including the same, there are techniques described in Patent Literature 1, Patent Literature 2, Non Patent Literature 1, Non Patent Literature 2, Non Patent Literature 3, Non Patent Literature 4, and Non Patent Literature 5.

For example, Non Patent Literature 2 discloses an optical element in which a heat sink is integrated with a laser medium and a total reflection film is provided between the laser medium and the heat sink.

### Citation List

### Patent Literature

Patent Literature 1: Japanese Patent No. 6245587
Patent Literature 2: Japanese Patent No. 4265287

### Non Patent Literature

Non Patent Literature 1: Masaki Tsunekane and Takunori Taira, "300 W continuous-wave operation of a diode edge-pumped, hybrid composite Yb: YAG microchip laser," OPTICS LETTERS, July 1, 2006, Vol. 31, No. 13, pp. 2003-2005.
Non Patent Literature 2: LIRE ZHENG, ARVYDAS KAUSAS, TAKUNORI TAIRA, "Drastic thermal effects reduction through distributed face cooling in a high power giantpulse tiny laser," OPTICAL MATERIALS EXPRESS, September 1, 2017, Vol. 7, No. 9, pp. 3214-3221.
Non Patent Literature 3: Eiji Higurashi and Yuichi Suga, "Wafer room-temperature bonding technology for realizing high heat dissipation structure in high-power semiconductor elements", Journal of Institute of Electronics Packaging, 2015, Vol. 18 No. 7, pp. 463 to 468.
Non Patent Literature 4: Siva Sankar Nagisetty, Patricie Severova, Taisuke Miura, Martin Smrz, Hitoe Kon, Miyuki Uomoto, Takehito Shimatsu, Masato Kawasaki, Takeshi Higashiguchi, Akira Endo and Tomas Mocek, "Lasing and thermal characteristics of Yb:YAG/YAG composite with atomic diffusion bonding," Laser Phys. Letters, 2017, Vol. 14, pp. 1-6.
Non Patent Literature 5: Masaki Tsunekane and Takunori Taira, "High-power operation of diode edge-pumped, composite all-ceramic Yb:Y3Al5O12 microchip laser," APPLIED PHYSICS LETTERS, 2007, Vol. 90, pp. 121101-1 to 121101-3.

### Summary of Invention

### Technical Problem

When the laser medium and the heat sink are integrated as in Non Patent Literature 2, heat generated in the laser medium is dissipated via the heat sink. Metals are used as heat sinks because of their higher thermal conductivity than dielectrics. In Non Patent Literature 2, a total reflection film is provided between the laser medium and the heat sink. Therefore, laser light generated or amplified using the laser medium is totally reflected by the total reflection film and output from a side opposite to the heat sink as viewed from the laser medium. The total reflection film can function as, for example, a part of an optical resonator. As in Non Patent Literature 2, when the total reflection film and the heat sink are in contact with each other and the heat sink is formed of a metal, the total reflection film and the metal are in contact with each other. In such a configuration, when the output of the laser light is extremely high, the metal in contact with the total reflection film is damaged, and as a result, the optical element including the laser medium, the total reflection film, and the metal heat sink cannot be stably used in some cases.

Therefore, an object of the present invention is to provide an optical element that can be stably used for high-output laser light, a laser system including the optical element, and a method for manufacturing the optical element.

### Solution to Problem

The inventors of the present application have found that, in a configuration in which a laser medium, a total reflection film, and a metal member are laminated in this order, the metal member is damaged by the influence of an evanescent wave generated when high-output laser light is incident on the total reflection film from the laser medium side, and have completed the present invention. Specifically, the present inventors have found that the evanescent wave generated by the total reflection of the laser light by the total reflection film penetrates into the metal member, a process in which the metal member absorbs the evanescent wave occurs, and the metal member is damaged, thereby achieving the present invention.

An optical element according to the present invention includes a laser medium; a first intermediate layer provided on the laser medium; a first metal layer formed on the first intermediate layer and including a Group 4 element or a Group 6 element; and a heat sink provided on the first metal layer and including a metal, in which the first intermediate layer includes a dielectric multilayer film that is formed on the laser medium and totally reflects laser light generated or amplified by the laser medium, and the first intermediate layer is thicker than a protrusion length of an evanescent wave generated by reflection of light incident from the laser medium side by the dielectric multilayer film.

In the above configuration, the first intermediate layer and the first metal layer are disposed between the laser medium and the heat sink from the laser medium side. The first intermediate layer includes the dielectric multilayer film that is formed on the laser medium and totally reflects laser light generated or amplified by the laser medium. In the above configuration, the dielectric multilayer film included in the first intermediate layer functions as a total reflection film. The first intermediate layer is thicker than the protrusion length of the evanescent wave generated by reflection of light incident from the laser medium side by the dielectric multilayer film. Therefore, even when high-output laser light is totally reflected by the dielectric multilayer film, the evanescent wave generated by the total reflection is not absorbed by the first metal layer and the heat sink. Therefore, the optical element can be stably used even for the high-output laser light.

The optical element according to an embodiment may further have a second metal layer disposed between the first metal layer and the heat sink and including a Group 10 element. In this case, a linear expansion coefficient of the second metal layer including the Group 10 element is a value between a linear expansion coefficient of the first metal layer and a linear expansion coefficient of the heat sink. Therefore, even when the laser medium generates heat, the optical element is less likely to be damaged as compared with a case where the second metal layer is not provided.

An example of a material of the second metal layer is nickel or platinum.

The optical element according to an embodiment may further have a second intermediate layer disposed between the first metal layer and the second metal layer. An example of a material of the intermediate layer is gold or a gold alloy.

An example of a material of the first metal layer is chromium or titanium.

Examples of a material of the heat sink may be copper, copper tungsten, copper molybdenum, iron, aluminum, or an aluminum-silicon carbide composite.

The first intermediate layer may have the dielectric multilayer film, and a nonmetallic heat transfer layer disposed between the dielectric multilayer film and the first metal layer.

Examples of a material of the nonmetallic heat transfer layer may be diamond, silicon carbide, or nitride.

A laser system according to another aspect of the present invention includes the optical element. Since this laser system includes the optical element, it is possible to stably output high-output laser light.

A method for manufacturing an optical element according to another aspect of the present invention includes: a preparation step of preparing a first component including a laser medium and a second component including a heat sink including a metal; and a joining step of joining the first component and the second component, in which the preparation step has a step of forming a first intermediate layer on the laser medium, and a step of forming a first metal layer including a Group 4 element or a Group 6 element on the first intermediate layer, in the joining step, the first component and the second component are joined via the first metal layer, the first intermediate layer includes a dielectric multilayer film that is formed on the laser medium and totally reflects laser light generated or amplified by the laser medium, and in the step of forming the first intermediate layer, the first intermediate layer is formed such that a thickness of the first intermediate layer is thicker than a protrusion length of an evanescent wave generated by reflection of light incident from the laser medium side by the dielectric multilayer film.

In this manufacturing method, it is possible to manufacture an optical element in which the first intermediate layer and the first metal layer are disposed between the laser medium and the heat sink from the laser medium side. The first metal layer includes the Group 4 element or the Group 6 element. In the optical element having the above configuration, the dielectric multilayer film included in the first intermediate layer functions as a total reflection film. The first intermediate layer is thicker than the protrusion length of the evanescent wave generated by reflection of light incident from the laser medium side by the dielectric multilayer film. Therefore, even when high-output laser light is totally reflected by the dielectric multilayer film, the evanescent wave generated by the total reflection is not absorbed by the first metal layer and the heat sink. Therefore, the optical element can be stably used even for the high-output laser light. Therefore, in the above manufacturing method, it is possible to manufacture an optical element that can be stably used even for high-output laser light.

The preparation step may have a step of forming a second metal layer including a Group 10 element on the heat sink, and in the joining step, the first component and the second component are joined via the first metal layer and the second metal layer. In this case, an optical element having the second metal layer between the first metal layer and the heat sink can be manufactured. A linear expansion coefficient of the second metal layer including the Group 10 element is a value between a linear expansion coefficient of the first metal layer and a linear expansion coefficient of the heat sink. Therefore, even when the laser medium generates heat, the optical element is less likely to be damaged as compared with a case where the second metal layer is not provided. That is, in the method for manufacturing an optical element including the step of forming the second metal layer including the Group 10 element, it is possible to manufacture an optical element that can be used more stably even for high-output laser light.

The preparation step may have a step of forming a layer to be a second intermediate layer disposed between the first metal layer and the second metal layer on at least one of the first metal layer and the second metal layer.

In the joining step, after a surface of the first component on a side to be joined to the second component and a surface of the second component on a side to be joined to the first component are subjected to a surface activation treatment, the first component and the second component subjected to the surface activation treatment are joined. In this case, the first component and the second component can be directly and firmly joined.

The method for manufacturing an optical element according to an embodiment may further have a step of subjecting a surface of the first component on a side to be joined to the second component and a surface of the second component on a side to be joined to the first component to a surface activation treatment, in which the preparation step further has a step of forming a second metal layer including a Group 10 element on the first metal layer, the second component is the heat sink, and in the joining step, the first component and the second component are joined via the second metal layer.

In this case, an optical element having the second metal layer between the first metal layer and the heat sink can be manufactured. A linear expansion coefficient of the second metal layer including the Group 10 element is a value between a linear expansion coefficient of the first metal layer and a linear expansion coefficient of the heat sink. Therefore, even when the laser medium generates heat, the optical element is less likely to be damaged as compared with a case where the second metal layer is not provided. That is, in the method for manufacturing an optical element including the step of forming the second metal layer including the Group 10 element, it is possible to manufacture an optical element that can be used more stably even for high-output laser light. The first component and the second component can be firmly and directly joined because the surface of the first component on the side to be joined to the second component and the surface of the second component on the side to be joined to the first component are subjected to the surface activation treatment to join the first component and the second component.

The step of forming the first intermediate layer may have a step of forming the dielectric multilayer film on the laser medium, and a step of forming a nonmetallic heat transfer layer on the dielectric multilayer film.

### Advantageous Effects of Invention

According to the present invention, it is possible to provide an optical element that can be stably used for high-output laser light, a laser system including the optical element, and a method for manufacturing the optical element.

### Brief Description of Drawings

FIG. 1 is a view illustrating a schematic configuration of an optical element according to a first embodiment.
FIG. 2 is a view for describing an example of a method for manufacturing the optical element illustrated in FIG. 1.
Fig. 3 is a view for describing another example of the method for manufacturing an optical element illustrated in FIG. 1.
FIG. 4 is a schematic view illustrating a schematic configuration of an optical element according to a second embodiment.
FIG. 5 is a view for describing an example of a method for manufacturing an optical element illustrated in FIG. 4.
FIG. 6 is a view for describing another example of the method for manufacturing an optical element illustrated in FIG. 4.
FIG. 7 is a schematic view illustrating a schematic configuration of an optical element according to a third embodiment.
FIG. 8 is a view for describing an example of a method for manufacturing an optical element illustrated in FIG. 7.
FIG. 9 is a schematic view of an example of a laser system using an optical element.
FIG. 10 is a schematic view illustrating another example of a laser system that is a laser oscillator.
FIG. 11 is a schematic view illustrating another example of a laser system that is a laser oscillator.
FIG. 12 is a schematic view illustrating another example of a laser system that is a laser oscillator.
FIG. 13 is a schematic view illustrating another example of a laser system using an optical element.
FIG. 14 is a schematic view illustrating another example of a laser system as a laser amplifier.
FIG. 15 is a schematic view of another example of a laser system using an optical element.
FIG. 16 is a schematic view illustrating another example of a laser system as a laser regeneration amplifier.
FIG. 17 is a schematic view illustrating another example of a laser system that is a laser regeneration amplifier.
FIG. 18 is a schematic view illustrating another example of a laser system that is a laser regeneration amplifier.
FIG. 19 is a schematic view illustrating a schematic configuration of another example of an optical element.
FIG. 20 is a schematic view illustrating a schematic configuration of another example of the optical element.
FIG. 21 is a schematic view illustrating a schematic configuration of another example of the optical element.

### Description of Embodiments

Hereinafter, embodiments of the present invention will be described in detail with reference to the accompanying drawings. In the description of the drawings, the same or equivalent elements are denoted by the same reference numerals, and redundant description is omitted. The dimensional ratios in the drawings do not necessarily coincide with those in the description.

### (First Embodiment)

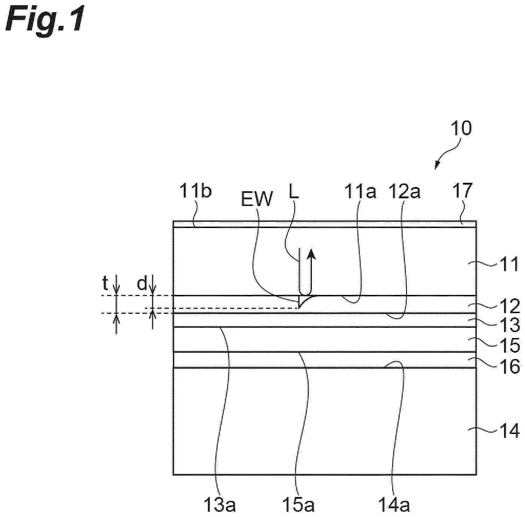

FIG. 1 is a view illustrating a schematic configuration of an optical element 10 according to an embodiment. The optical element 10 illustrated in FIG. 1 includes a laser medium 11, a dielectric multilayer film (first intermediate layer) 12, a first metal layer 13, and a heat sink 14. The optical element 10 is a laser medium with a heat sink having a total reflection function by a dielectric multilayer film 12. The optical element 10 is applied to a laser oscillator, a laser amplifier, and the like. The optical element 10 may have an intermediate layer (second intermediate layer) 15. The optical element 10 may have a second metal layer 16. Hereinafter, unless otherwise specified, an aspect having the intermediate layer 15 and the second metal layer 16 will be described.

The laser medium 11 is a substance that forms an inverted distribution in which amplification exceeds loss in an excited state and amplifies light using stimulated emission. The laser medium 11 is an optical component for oscillation or amplification of laser light L. The laser medium 11 is also referred to as a gain medium.

Examples of a material of the laser medium 11 include an optical gain material formed of an oxide to which a rare earth ion as a center of emission is added, an optical gain material formed of an oxide to which a transition metal ion as a center of emission is added, an optical gain material formed of an oxide as a color center, an optical gain material formed of a semiconductor, and the like.

Examples of the rare earth ion include Ce, Pr, Nd, Pm, Sm, Eu, Gd, Tb, Dy, Ho, Er, Tm, and Yb. Examples of the transition metal ion include Ti, V, Cr, Mn, Fe, Co, Ni, and Cu. Examples of a base material to which rare earth ions, transition metal ions, and the like are added include garnet-based materials such as YAG, YSAG, YGAG, YSGG, GGG, GSGG, and LuAG, fluorine-based materials such as YLF, LiSAF, LiCAF, MgF₂, and CaF₂, vanadate-based materials such as YVO₄, GdVO₄, and LuVO₄, apatitic materials such as FAP, sFAP, VAP, and sVAP, alumina-based materials such as Al₂O₃ and BeAl₂O₃, ditrioxide-based materials such as Y₂O₃, Sc₂O₃, and Lu₂O₃, and tungstate-based materials such as KGW and KYW. The state of the laser medium 11 may be single crystal, amorphous (including glass), or ceramic. The base material may be various amorphous glasses. Examples of the semiconductor include GaAs, GaAlAs, GaAlP, GaP, GaN, InGaN, AlGaN, and GaAlN.

The dielectric multilayer film 12 is formed on a first surface 11a of the laser medium 11. The dielectric multilayer film 12 totally reflects the laser light L generated or amplified by stimulated emission of the laser medium 11. In one embodiment, the dielectric multilayer film 12 functions as an HR coating layer with respect to the laser light L. The dielectric multilayer film 12 may reflect light having a wavelength other than a wavelength of the laser light L. The dielectric multilayer film 12 is configured by alternately laminating a plurality of high refractive index layers and a plurality of low refractive index layers (layers having a refractive index smaller than that of the high refractive index layer). In the dielectric multilayer film 12, desired reflection characteristics can be realized by adjusting a refractive index and a thickness of each of the high refractive index layer and the low refractive index layer. The dielectric multilayer film 12 has a thickness such that an evanescent wave EW generated when the laser light L is totally reflected does not reach the first metal layer 13. In other words, a thickness t of the dielectric multilayer film 12 is longer than a protrusion length d of the evanescent wave EW. The dielectric multilayer film 12 is, for example, a multilayer film including a plurality of layers of 10 nm or more and 9000 nm or less (100 Å or more and 90000 Å or less). Therefore, an example of the thickness t of the dielectric multilayer film 12 is about several µm. The thickness t may be 10 µm or more depending on the wavelength of light reflected by the dielectric multilayer film 12. However, the dielectric multilayer film 12 is preferably thin. As a material of a layer closest to the first metal layer 13 in the dielectric multilayer film 12, Al₂O₃ having a high thermal conductivity is mainly suitable, but SiO₂ may be used.

The first metal layer 13 is formed on a first surface 12a of the dielectric multilayer film 12. The first surface 12a is a surface of the dielectric multilayer film 12 opposite to the laser medium 11. The first metal layer 13 functions as a buffer layer in a case of joining the laser medium 11 and the heat sink 14 having different linear expansion coefficients. The first metal layer 13 includes a metal material having a linear expansion coefficient close to that of the laser medium 11. The first metal layer 13 includes a Group 4 element or a Group 6 element. An example of the Group 4 element is titanium (Ti), and an example of the Group 6 element is chromium (Cr). An example of a thickness of the first metal layer 13 is 1 nm or more and 900 nm or less (10 Å or more and 9000 Å or less). An Ni layer or a Pt layer may be provided on the opposite side of the first metal layer 13 from the dielectric multilayer film 12 in order to prevent migration that is feared when temperature raising processing is required. An example of a thickness of the Ni layer or the Pt layer is 10 nm or more and 900 nm or less (100 Å or more and 9000 Å or less).

The heat sink 14 is a heat transfer body for cooling the laser medium 11 and includes a metal. The heat sink 14 is, for example, a metal heat sink. The heat sink 14 is made of a material having high thermal conductivity. Examples of a material of the heat sink 14 include copper, a copper alloy, aluminum, iron, an aluminum-silicon carbide composite, and the like. Examples of the copper alloy include copper tungsten and copper molybdenum.

The intermediate layer 15 is formed on a first surface 13a of the first metal layer 13. The first surface 13a is a surface of the first metal layer 13 opposite to the dielectric multilayer film 12. The intermediate layer 15 also functions as a buffer layer. The material of the intermediate layer 15 is gold or a gold alloy. An example of a thickness of the intermediate layer 15 is 5 nm or more and 10 µm or less.

The second metal layer 16 is formed on a first surface 15a of the intermediate layer 15. The first surface 15a is a surface of the intermediate layer 15 opposite to the first metal layer 13. In the arrangement illustrated in FIG. 1, the second metal layer 16 is formed on a first surface 14a of the heat sink 14. The second metal layer 16 also functions as a buffer layer. The second metal layer 16 is formed of a material having a linear expansion coefficient close to (or between) a linear expansion coefficient of the first metal layer 13 and a linear expansion coefficient of the heat sink 14. The second metal layer 16 includes a Group 10 element. An example of a material of the second metal layer 16 is nickel (Ni) or platinum (Pt). A thickness of the second metal layer 16 is, for example, 10 nm or more and 900 nm or less (100 Å or more and 9000 Å or less). When the temperature raising processing is required, the thickness of the second metal layer 16 is, for example, about 0.1 µm or more and 10 µm or less.

A dielectric multilayer film 17 for suppressing reflection of the laser light L may be formed on a second surface 11b of the laser medium 11 included in the optical element 10. The dielectric multilayer film 17 functions as an antireflection film (AR coating) for the laser light L.

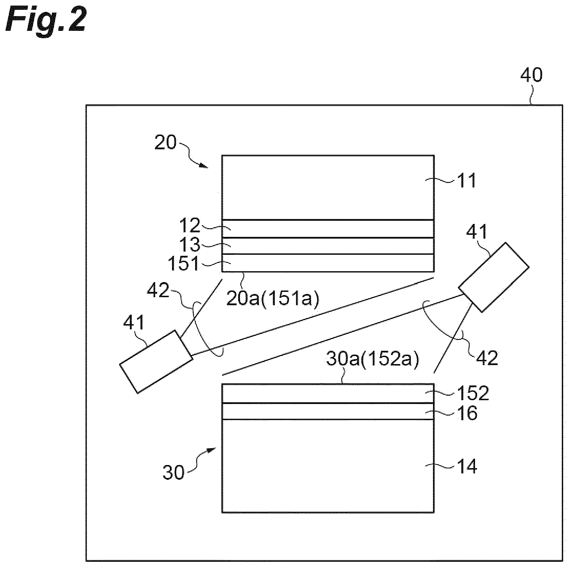

An example of a method for manufacturing the optical element 10 will be described with reference to FIG. 2. FIG. 2 is a view for describing an example of a method for manufacturing the optical element 10 illustrated in FIG. 1. As illustrated in FIG. 1, a case of manufacturing the optical element 10 having the dielectric multilayer film 12, the first metal layer 13, the intermediate layer 15, and the second metal layer 16 between the laser medium 11 and the heat sink 14 will be described.

In the case of manufacturing the optical element 10, a first component 20 including the laser medium 11 and a second component 30 including the heat sink 14 are prepared (preparation step).

The preparation step has a step of preparing the first component 20 and a step of preparing the second component 30. An order of the step of preparing each of the first component 20 and the second component 30 is not limited.

In the step of preparing the first component 20, a step of forming the dielectric multilayer film 12 on the laser medium 11, a step of forming the first metal layer 13 on the dielectric multilayer film 12, and a step of forming the intermediate layer 151 on the first metal layer 13 are sequentially performed. The dielectric multilayer film 12, the first metal layer 13, and the intermediate layer 151 can be formed by a film forming technique, a thin film technique, or the like.

Since the conditions and the like satisfied by the dielectric multilayer film 12 and the first metal layer 13 are as described above, the description thereof is omitted. The intermediate layer 151 is a layer configuring the intermediate layer 15 illustrated in FIG. 1 by being joined to an intermediate layer 152 included in the second component 30 to be described later. Therefore, the material of the intermediate layer 151 is the same as that of the intermediate layer 15. A thickness of the intermediate layer 151 is a thickness in which a sum of a thickness of the intermediate layer 151 and a thickness of the intermediate layer 152 corresponds to the thickness of the intermediate layer 15.

In a case where the optical element 10 has the dielectric multilayer film 17, the step of preparing the first component 20 includes a step of forming the dielectric multilayer film 17.

In the step of preparing the second component 30, a step of forming the second metal layer 16 on the heat sink 14 and a step of forming the intermediate layer 152 on the second metal layer 16 are sequentially performed. The second metal layer 16 and the intermediate layer 152 can be formed by a film forming technique, a thin film technique, or the like.

Since the conditions and the like satisfied by the second metal layer 16 are as described above, the description thereof is omitted. The intermediate layer 152 is a layer configuring the intermediate layer 15 illustrated in FIG. 1 by being joined to the intermediate layer 151 included in the first component 20 described above. Therefore, the material of the intermediate layer 152 is the same as that of the intermediate layer 15. The thickness of the intermediate layer 152 is a thickness in which a sum of the thickness of the intermediate layer 152 and the thickness of the intermediate layer 151 corresponds to the thickness of the intermediate layer 15.

After the first component 20 and the second component 30 are prepared, they are joined (joining step). An example of the joining method will be specifically described. In the present embodiment, the first component 20 and the second component 30 are joined using surface active joining. The surface active joining is a method for joining flat joint surfaces with exposed constituent atoms, and can significantly lower a joining temperature as compared with other joining methods.

Specifically, the first component 20 and the second component 30 are disposed in a chamber 40, and the inside of the chamber 40 is in a substantially vacuum environment. Under the substantially vacuum environment, a joint surface 20a of the first component 20 and a joint surface 30a of the second component 30 are irradiated with a surface active beam 42 from a beam source 41.

The joint surface 20a is a surface of the first component 20 to be joined to the second component 30. In the aspect illustrated in FIG. 2, the joint surface 20a is a first surface 151a of the intermediate layer 151. The joint surface 30a is a surface of the second component 30 to be joined to the first component 20. In the aspect illustrated in FIG. 2, the joint surface 30a is a first surface 152a of the intermediate layer 152.

An example of the surface active beam 42 is an ion beam such as argon (Ar) or a fast atom beam (FAB). As a result, the surface (in the present embodiment, the joint surface 20a and the joint surface 30a) irradiated with the surface active beam 42 is activated. Specifically, oxygen and the like adsorbed on the surface are removed, and a new surface including a dangling bond is formed. The substantially vacuum environment is, for example, a vacuum or reduced pressure atmosphere having a background pressure of 1 × 10⁻⁶ Pa or more and less than the atmospheric pressure.

As the ion beam or FAB, in addition to argon, a beam using a rare gas or an inert gas such as neon (Ne), krypton (Kr), xenon (Xe), or helium (He) can be adopted. Since the rare gas hardly causes a chemical reaction, the rare gas does not significantly change the chemical properties of the irradiated surface. An example of the beam source 41 is a particle beam source or a plasma generator. By accelerating the particles of the ion beam toward the joint surface 20a and the joint surface 30a using the particle beam source or the plasma generator, predetermined kinetic energy can be applied to the ion beam or the FAB.

After the surface activation treatment is applied to the joint surface 20a and the joint surface 30a, the joint surface 20a and the joint surface 30a are opposed to each other. At a room temperature, new surfaces (the joint surface 20a and the joint surface 30a subjected to the surface activation treatment) where the joining hands of the first component 20 and the second component 30 are exposed are brought into contact with each other in a substantially vacuum environment. As a result, a joining force due to an interaction between atoms is generated. As a result, the first component 20 and the second component 30 are firmly joined, and the optical element 10 is obtained. The substantially vacuum environment is, for example, a vacuum or reduced pressure atmosphere having a background pressure of 1.5 × 10⁻⁶ Pa or less. A predetermined pressure (1.5 to 2.0 MPa) may be applied to the first component 20 and the second component 30 brought into contact with each other.

The joint surface 20a and the joint surface 30a may be amorphized by the surface activation treatment. In this case, the first component 20 and the second component 30 are joined via the amorphous layer. Amorphous is a substance having no long-range order but having short-range order as in crystals. The amorphous state is a state in which the crystal structure is collapsed. The amorphous layer is a layer having crystallinity lower than a certain level.

The amorphous layer includes elements (hereinafter, referred to as "beam element") configuring the ion beam or FAB and a casing material configuring a beam casing of the ion beam or FAB as impurities other than the substances configuring the heat sink 14 and the laser medium 11. The beam element is, for example, Ar (argon) or Ne (neon). The casing material is, for example, Fe (iron), Ni (nickel), or Cr (chromium). The amount of the beam element included in the amorphous layer is so small that the oscillation or amplification of the laser light L is not affected.

After the first component 20 and the second component 30 are joined via the amorphous layer, the optical element 10 may be subjected to a heating treatment in a heating furnace, and the temperature of the optical element 10 may be raised to a predetermined temperature. As a result, the optical element 10 is annealed, and the amorphous layer of the optical element 10 is epitaxially grown and crystallized.

The predetermined temperature (also referred to as a crystallization temperature or an epi growth temperature) is a temperature lower than melting point of the heat sink 14 and the laser medium 11. The predetermined temperature is 100°C or higher and lower than the melting point of the substance configuring the amorphous layer. In one embodiment, the predetermined temperature is about 865°C which is about a half of about 2000°C which is the melting point of the heat sink 14 and the laser medium 11. The predetermined temperature is, for example, 1900°C or lower. The predetermined temperature is a low temperature that does not affect the dielectric multilayer film 12, and is, for example, 200°C or 300°C. The heating time of the optical element 10 is, for example, several hours to several tens of hours. For example, in a case of a long-time temperature raising treatment, the predetermined temperature may be 100°C or lower.

Here, the case where the surface activation treatment is performed in the joining step has been described. However, the surface activation treatment may be omitted. Au is the most stable material, and can be stored for a long period of time while maintaining surface activity by adjusting storage conditions. Therefore, when the intermediate layer 15 is made of Au and can be stored for a long period of time while maintaining the surface activity, the surface activation treatment may be omitted.

In the optical element 10, the dielectric multilayer film 12 functions as a total reflection film. The thickness t of the dielectric multilayer film 12 is thicker than the protrusion length d of the evanescent wave EW generated by the reflection of the laser light L incident from the laser medium 11 side. In such a configuration, even when the high-output laser light L is totally reflected by the dielectric multilayer film 12, the evanescent wave EW generated by the total reflection is not absorbed by the first metal layer 13, the heat sink 14, and the like. Therefore, the optical element 10 can be stably used even for the high-output laser light L. The high-output laser light L is a laser light having an average output of 1 kW or more (for example, megawatts or more).

The first metal layer 13 includes a Group 4 element (for example, Ti) or a Group 6 element (for example, Cr). The linear expansion coefficient of the first metal layer 13 is between the linear expansion coefficient of the dielectric (laser medium 11, dielectric multilayer film 12, and the like) and the linear expansion coefficient of the heat sink 14. Therefore, as compared with the case where the first metal layer 13 is not provided, the linear expansion coefficient changes stepwise from the laser medium 11 side toward the heat sink 14 inside the optical element 10. That is, the rate of change in the linear expansion coefficient from the laser medium 11 side toward the heat sink 14 is smaller than the case where the first metal layer 13 is not provided. Therefore, for example, even when heat is generated in the laser medium 11 due to the influence of the high-output laser light L, the optical element 10 is hardly damaged.

The second metal layer 16 includes a 10th element (for example, Ni, Pt, and the like). The linear expansion coefficient of the second metal layer 16 is between the linear expansion coefficient of the first metal layer 13 and the linear expansion coefficient of the heat sink 14. Therefore, in the aspect including the second metal layer 16, the linear expansion coefficient changes stepwise from the laser medium 11 side toward the heat sink 14 inside the optical element 10 as compared with the case where the second metal layer 16 is not provided. That is, the rate of change in the linear expansion coefficient from the laser medium 11 side toward the heat sink 14 is smaller than the case where the second metal layer 16 is not provided. Therefore, in the aspect including the second metal layer 16, for example, even when heat is generated in the laser medium 11 due to the influence of the high-output laser light L, the optical element 10 is more hardly damaged.

In the example of the method for manufacturing the optical element described with reference to FIG. 2, the optical element 10 can be manufactured. That is, in the example of the method for manufacturing the optical element described with reference to FIG. 2, the optical element 10 that can be stably used for the high-output laser light L can be manufactured.

As illustrated in FIG. 2, when the optical element 10 is manufactured by using the surface active joining, the first component 20 including the laser medium 11 and the second component 30 including the heat sink 14 can be directly (specifically, by using a joining force due to an interaction between atoms) joined, so that they can be firmly joined. In this case, since an adhesive layer or the like is not interposed, the optical element 10 is hardly damaged by the influence of heat generated in the laser medium 11.

In the aspect in which the intermediate layer 15 is provided and the intermediate layer 15 is formed of Au or an Au alloy, as in the example of the manufacturing method described with reference to FIG. 2, the optical element 10 can be manufactured using the first component 20 and the second component 30 having the intermediate layer 151 and the intermediate layer 152 to be the intermediate layer 15 on the joining side. Since Au or the like is hardly oxidized, it is easy to keep the joint surface 20a and the joint surface 30a clean. As a result, the first component 20 and the second component 30 can be more firmly joined. When the intermediate layer 15 is formed of Au, the surface activation treatment may be omitted as described above. As a result, the optical element 10 can be easily manufactured.

### (First Modification)

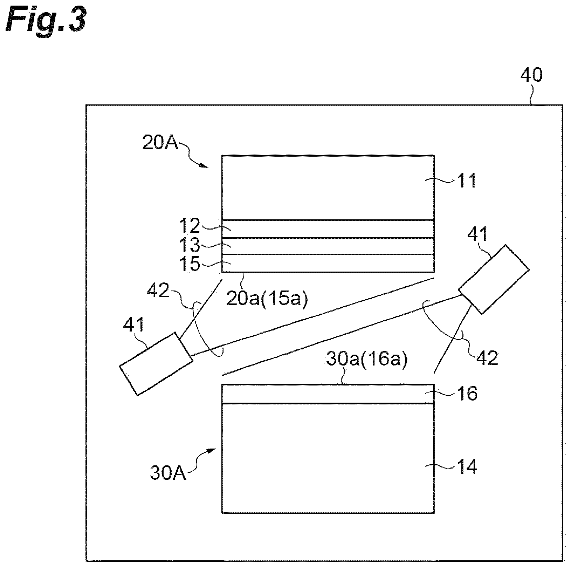

In the method for manufacturing the optical element 10 described with reference to FIG. 2, the intermediate layer 15 is disposed on the first component 20 and the second component 30 by being divided into the intermediate layer 151 and the intermediate layer 152. However, as illustrated in FIG. 3, the optical element 10 may be manufactured using a second component 30A not having the intermediate layer 152 and a first component 20A having the intermediate layer 15 instead of the intermediate layer 151.

The first component 20A is the same as the first component 20 except that it has the intermediate layer 15 instead of the intermediate layer 151. In the first component 20A, the first surface 15a of the intermediate layer 15 is the joint surface 20a. A preparation method of the first component 20A is also the same as the preparation method of the first component 20 except that the intermediate layer 15 is formed instead of the intermediate layer 151.

The second component 30A is the same as the second component 30 except that it does not have the intermediate layer 152. The second component 30 is a laminate of the heat sink 14 and the second metal layer 16, and a first surface 16a of the second metal layer 16 is the joint surface 30a. The first surface 16a is a surface of the second metal layer 16 opposite to the heat sink 14. A preparation method of the second component 30A is also the same as the preparation method of the second component 30 except that the intermediate layer 152 is not formed.

The method for manufacturing the optical element 10 in the case of using the first component 20A and the second component 30A is similar to the case described with reference to FIG. 2 except that the first component 20A and the second component 30A are used instead of the first component 20 and the second component 30. Therefore, the manufacturing method of the first modification has the same operation and effect as those of the manufacturing method described with reference to FIG. 2.

The joint surface 30a of the second component 30A is the first surface 16a of the second metal layer 16. Since an oxide film is easily formed on the first surface 16a of the second metal layer 16, in the first modification, before joining the first component 20A and the second component 30A, the surface activation treatment of the joint surface 30a is performed by the surface active beam 42 as in the case described with reference to FIG. 2. Conditions for the surface activation treatment are similar to those described with reference to FIG. 2. In order to perform the surface activation treatment on the second component 30A, the surface activation treatment is usually also performed on the first component 20A. However, the first component 20A has the intermediate layer 15. Therefore, as in the case of the first component 20, the surface activation treatment may be omitted when the intermediate layer 15 is formed of Au, the substance is stable, and the storage state is good.

### (Second Embodiment)

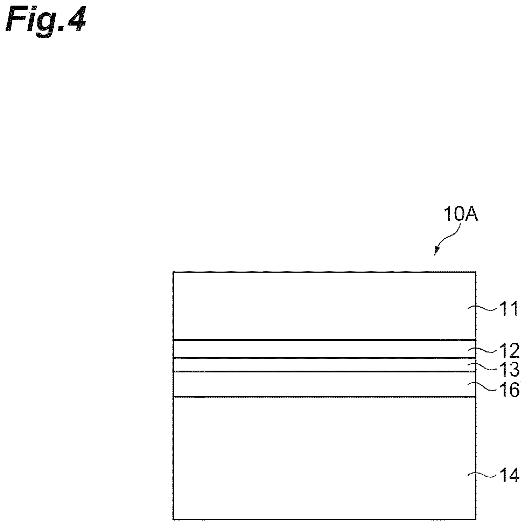

FIG. 4 is a schematic view illustrating a schematic configuration of an optical element 10A according to a second embodiment. The optical element 10 is different from the optical element 10 in that it does not have the intermediate layer 15. In the optical element 10A, the first metal layer 13 and the second metal layer 16 are in contact with each other. The configuration of the optical element 10A other than the above difference is similar to that of the optical element 10. Therefore, the optical element 10A has the same operation and effect as those of the optical element 10. Although not illustrated in FIG. 4, the optical element 10A may also have the dielectric multilayer film 17 functioning as an antireflection film.

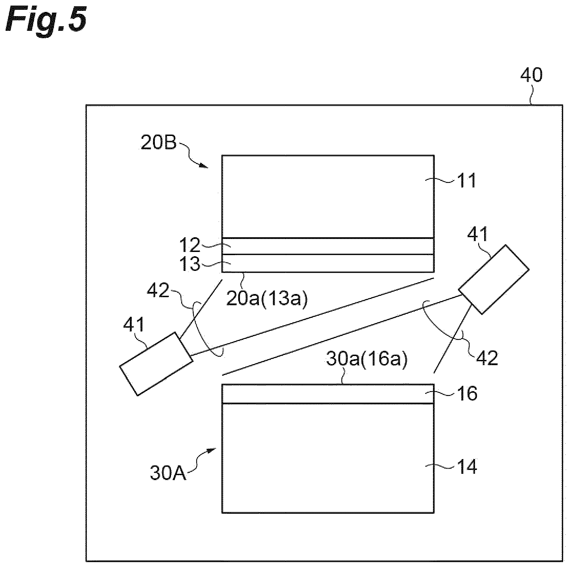

An example of a method for manufacturing the optical element 10A will be described. The method for manufacturing the optical element 10A is similar to the method for manufacturing the optical element 10 except that a first component 20B and a second component 30A illustrated in FIG. 5 are prepared and joined to manufacture the optical element 10A. Therefore, the method for manufacturing the optical element 10A has the same operation and effect as those of the method for manufacturing the optical element 10.

The first component 20B is different from the first component 20 in that it does not have the intermediate layer 151. The configuration of the first component 20B other than this difference is similar to that of the first component 20. The joint surface 20a of the first component 20B is the first surface 13a of the first metal layer 13. A preparation method of the first component 20B is similar to that of the first component 20 except that the intermediate layer 151 is not formed.

Since the second component 30A is the same as the second component 30A described in the first modification, the description thereof will be omitted. The joint surface 30a of the second component 30A is the first surface 16a of the second metal layer 16.

The joint surface 20a of the first component 20B is the first surface 13a of the first metal layer 13, and the joint surface 30a of the second component 30A is the first surface 16a of the second metal layer 16. An oxide film is easily formed on the first surface 13a and the first surface 16a. Therefore, in the case of surface active joining of the first component 20B and the second component 30A, similarly to the case described with reference to FIG. 2, the surface activation treatment is performed on the joint surface 20a and the joint surface 30a using the surface active beam 42. Conditions for the surface activation treatment are similar to those described with reference to FIG. 2.

### (Second Modification)

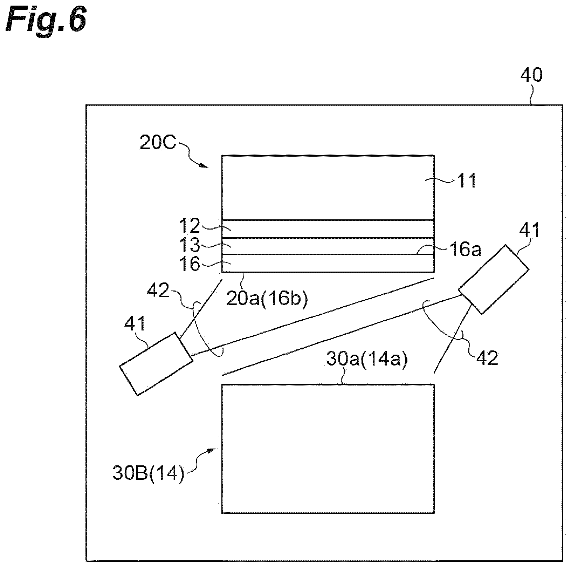

In the method for manufacturing the optical element 10A described with reference to FIG. 5, the second component 30A has the second metal layer 16. However, as illustrated in FIG. 6, the optical element 10A may be manufactured using a first component 20C having the second metal layer 16 and a second component 30B not having the second metal layer 16.

The first component 20C is similar to the first component 20B except that the second metal layer 16 is formed on the first metal layer 13. The joint surface 20a of the first component 20C is a second surface 16b of the second metal layer 16. The second surface 16b is a surface of the second metal layer 16 opposite to the first surface 16a. A preparation method of the first component 20C is the same as a preparation method of the first component 20B except that the second metal layer 16 is further formed on the first metal layer 13.

The second component 30B is similar to the second component 30A except that it does not have the second metal layer 16. Therefore, in the second modification, the second component 30B is the heat sink 14, and the joint surface 30a of the second component 30B is the first surface 14a of the heat sink 14.

The method for manufacturing the optical element 10A in the case of using the first component 20C and the second component 30B is similar to the case described with reference to FIG. 5 except that the first component 20C and the second component 30B are used instead of the first component 20B and the second component 30A. Oxide films are easily formed on the second surface 16b of the second metal layer 16 which is the joint surface 20a and the first surface 14a of the heat sink 14 which is the joint surface 30a. Therefore, also in the second modification, in the case of surface active joining of the first component 20C and the second component 30B, similarly to the case described with reference to FIG. 2, the surface activation treatment is performed on the joint surface 20a and the joint surface 30a using the surface active beam 42. Conditions for the surface activation treatment are similar to those described with reference to FIG. 2.

The manufacturing method of the second modification is similar to the method for manufacturing the optical element 10A described with reference to FIG. 5 except that the first component 20C and the second component 30B are used instead of the first component 20B and the second component 30A. Therefore, the manufacturing method of the second modification has the same operation and effect as those of the method for manufacturing the optical element 10A described with reference to FIG. 5.

### (Third Embodiment)

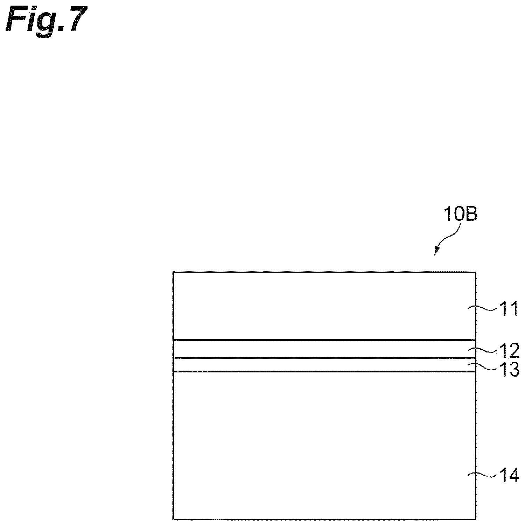

FIG. 7 is a schematic view illustrating a schematic configuration of an optical element 10B according to a third embodiment. The optical element 10B is different from the optical element 10 in that it does not have the intermediate layer 15 and the second metal layer 16. In the optical element 10B, the heat sink 14 is disposed on the first metal layer 13. The configuration of the optical element 10B other than the above difference is similar to that of the optical element 10. Therefore, the optical element 10B has the same operation and effect as those of the optical element 10.

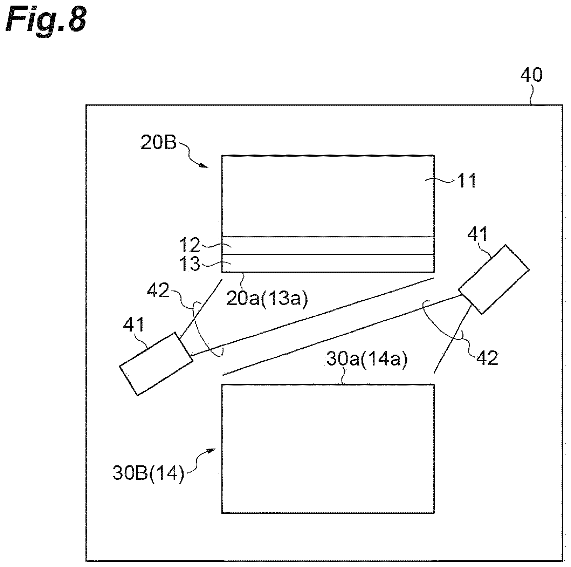

An example of a method for manufacturing the optical element 10B will be described. The method for manufacturing the optical element 10B is similar to the method for manufacturing the optical element 10 except that the first component 20B and the second component 30B illustrated in FIG. 8 are prepared and joined to manufacture the optical element 10B. Therefore, the method for manufacturing the optical element 10B has the same operation and effect as those of the method for manufacturing the optical element 10.

Since the first component 20B is the same as the first component 20B illustrated in FIG. 5, the description thereof will be omitted. Since the second component 30B is the same as the second component 30B illustrated in FIG. 6, the description thereof will be omitted.

As described with reference to FIG. 5, the joint surface 20a of the first component 20B is the first surface 13a of the first metal layer 13. As described with reference to FIG. 6, the joint surface 30a of the second component 30B is the first surface 14a of the heat sink 14. An oxide film is easily formed on the first surface 13a and the first surface 14a. When the first component 20B and the second component 30B are subjected to surface active joining in the manufacture of the optical element 10B, the surface activation treatment is performed on the joint surface 20a and the joint surface 30a using the surface active beam 42 as in the case described with reference to FIG. 2. Conditions for the surface activation treatment are similar to those described with reference to FIG. 2.

Next, various aspects of a laser system using an optical element will be described. Hereinafter, an aspect using the optical element 10 will be described, but the optical element 10A and the optical element 10B can be adopted instead of the optical element 10. A laser system using the optical element 10 (the optical element 10A or the optical element 10B) can be applied to measurement, analysis, display, processing, and medical (including diagnosis and treatment), and may be incorporated into a system in the exemplified field.

### (Fourth Embodiment)

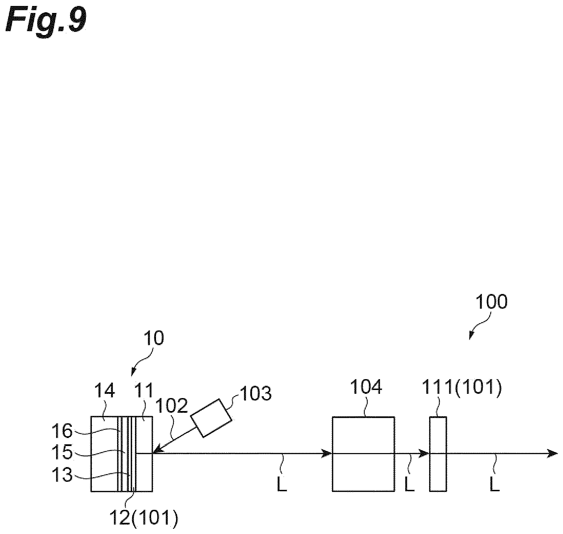

FIG. 9 is a schematic view of an example of a laser system using an optical element. A laser system 100 illustrated in FIG. 9 is a laser oscillator. As illustrated in FIG. 9, the laser system 100 has the optical element 10 and an output mirror 111.

In the laser system 100, the dielectric multilayer film 12 included in the optical element 10 functions as a total reflection mirror for the laser light L. In the laser system 100, the dielectric multilayer film 12 and the output mirror 111 configure an optical resonator 101. The optical element 10 is disposed such that the laser medium 11 is located in the optical resonator 101. The output mirror 111 may have reflection and transmission characteristics that function as the output mirror 111 in the optical resonator 101. The output mirror 111 may be a partially reflective mirror.

When the laser system 100 outputs the laser light L, the laser medium 11 is irradiated with excitation light 102. As a result, stimulated emission light is generated in the laser medium 11, and the stimulated emission light propagates in the optical resonator 101. As a result, laser oscillation occurs, and the laser light L is output from the output mirror 111.

The laser system 100 may have a light source unit 103 that outputs the excitation light 102. The laser system 100 may have a Q switch element 104 between the optical element 10 and the output mirror 111 in the optical resonator 101. The Q switch element 104 may be a known Q switch element. The laser system 100 may have a mode lock element instead of the Q switch element 104, or may have a wavelength conversion element. The mode lock element and the wavelength conversion element may also be a known mode lock element and a known wavelength conversion element. In a case where the laser system 100 includes a wavelength conversion element disposed on the output side of the laser system 100 with respect to the optical element 10, the output mirror 111 may have a wavelength separation function.

The laser system 100 includes the optical element 10. As described in the first embodiment, since the optical element 10 is less likely to be damaged with respect to the high-output laser light L, as a result, the laser system 100 can be stably used. Therefore, the laser system 100 can also stably output the high-output laser light L.

Since the laser system 100 includes the optical element 10 that can be stably used for the high-output laser light L, it is easy to stably output a high-output short-pulse laser light using the Q switch element 104. Therefore, the optical element 10 can be more effectively applied to a laser system having the Q switch element 104.

### (Third Modification)

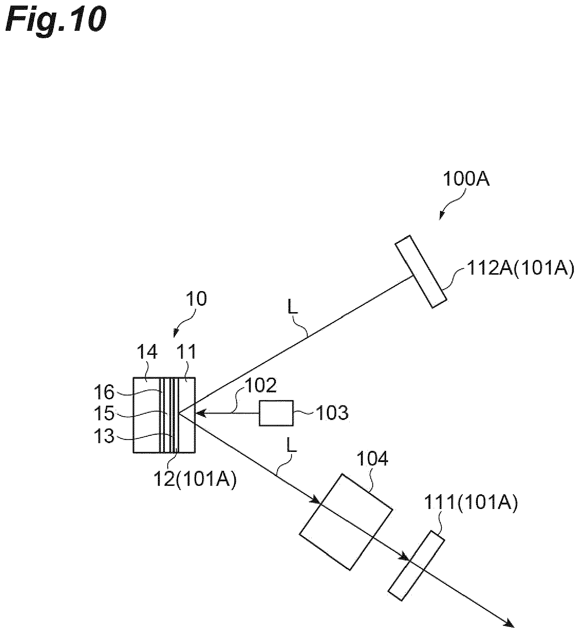

FIG. 10 is a schematic view illustrating another example of a laser system that is a laser oscillator. A laser system 100A further includes a first total reflection mirror 112A, and is mainly different from the laser system 100 in that an optical resonator 101A is configured by the dielectric multilayer film 12 of the optical element 10, the output mirror 111, and the first total reflection mirror 112A. Since the laser system 100A also includes the optical element 10, the same operation and effect as those of the laser system 100 are obtained.

The laser system 100A may include the Q switch element 104 as in the case of the laser system 100. The laser system 100A may include the mode lock element or the wavelength conversion element instead of the Q switch element 104. In a case where the laser system 100A includes the wavelength conversion element, the output mirror 111 may have the wavelength separation function similarly to the case of the laser system 100.

In the laser system 100A, since the dielectric multilayer film 12, the output mirror 111, and the first total reflection mirror 112A configure the optical resonator 101, an optical path of the laser light L from the first total reflection mirror 112A to the output mirror 111 is bent at a position of the dielectric multilayer film 12.

The laser system 100A may also include the light source unit 103 that outputs the excitation light 102.

### (Fourth Modification)

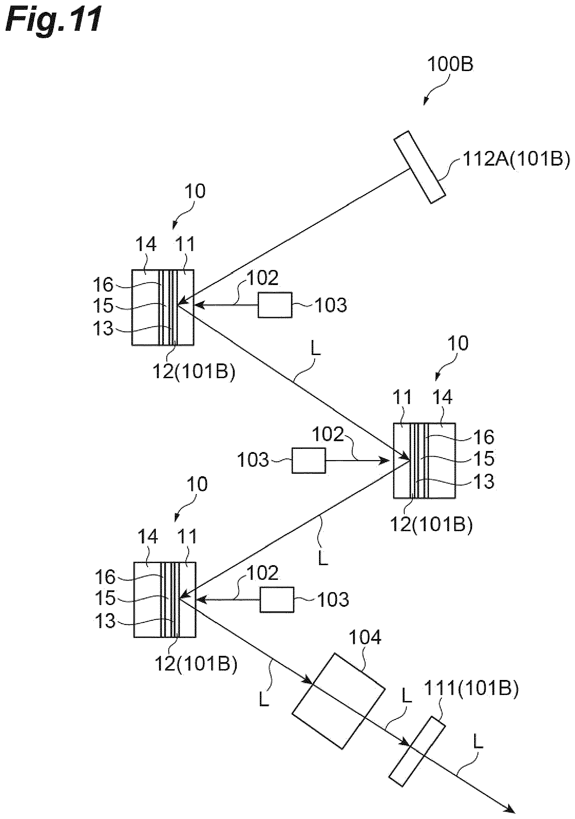

FIG. 11 is a schematic view illustrating another example of a laser system that is a laser oscillator. A laser system 100B is mainly different from the laser system 100A in that a plurality of optical elements 10 are provided between the first total reflection mirror 112A and the output mirror 111. The laser system 100B is a multistage medium type laser oscillator.

Since the laser system 100B also includes the optical element 10, the laser system 100B has an operation and effect similar to those of the laser system 100 and the laser system 100A. The laser system 100B includes a plurality of optical elements 10, and the laser light L is amplified by each optical element 10. Therefore, the laser system 100B can output the laser light L having a higher output. As described above, even in a case where the output of the laser light L is higher, the laser system 100B is hardly damaged by using the optical element 10, and as a result, it is easy to stably use the laser system. Therefore, the optical element 10 can be more effectively applied to the multistage medium type laser oscillator such as the laser system 100B.

The laser system 100B may include the Q switch element 104 as in the case of the laser system 100 and the laser system 100A. The laser system 100B may include the mode lock element or the wavelength conversion element instead of the Q switch element 104. In a case where the laser system 100B includes the wavelength conversion element, the output mirror 111 may have the wavelength separation function similarly to the case of the laser system 100 and the laser system 100A.

In the laser system 100B, the dielectric multilayer film 12 included in each of the plurality of optical elements 10, the output mirror 111, and the first total reflection mirror 112A configure an optical resonator 101B. Therefore, the optical path of the laser light L from the total reflection mirror to the output mirror 111 is bent at the position of each dielectric multilayer film 12.

The laser system 100B may also include the light source unit 103 that outputs the excitation light 102.

### (Fifth Modification)

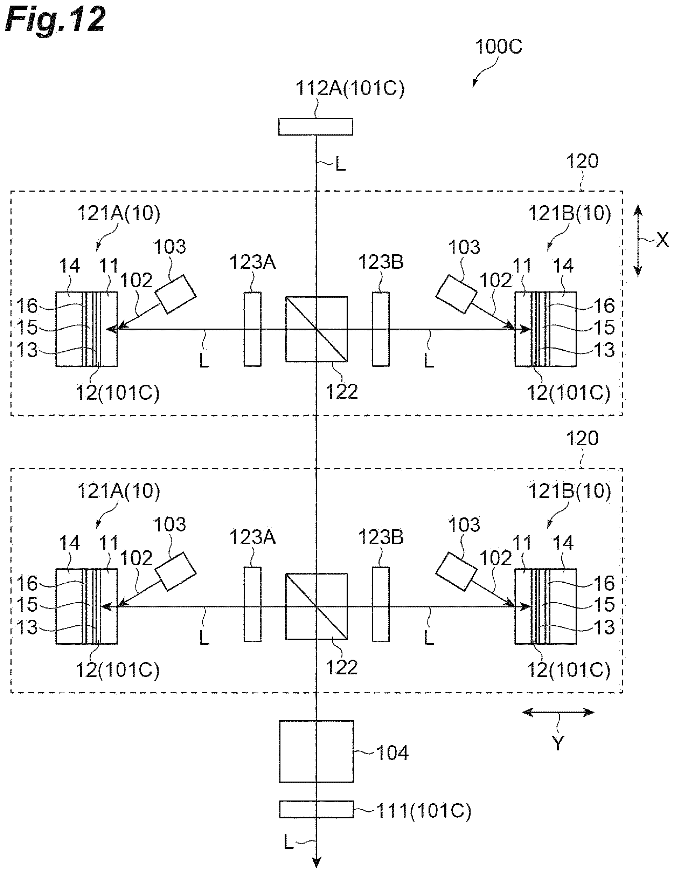

FIG. 12 is a schematic view illustrating another example of a laser system that is a laser oscillator. A laser system 100C is another example of a multistage medium type laser oscillator.

The laser system 100C includes the first total reflection mirror 112A, the output mirror 111, and a plurality of element sets 120. The first total reflection mirror 112A and the output mirror 111 are disposed along a first direction X.

Each of the plurality of element sets 120 includes a first optical element 121A, a second optical element 121B, a polarization beam splitter 122, a first wavelength plate 123A, and a second wavelength plate 123B.

Each of the first optical element 121A and the second optical element 121B is the same element as the optical element 10. The first optical element 121A and the second optical element 121B are separated in a direction (in FIG. 12, a direction orthogonal to the first direction X) crossing the first direction X, and are disposed such that the laser media 11 included in the first optical element 121A and the second optical element 121B face each other.

The polarization beam splitter 122 is disposed between the first optical element 121A and the second optical element 121B.

The first wavelength plate 123A is disposed between the first optical element 121A and the polarization beam splitter 122. The first wavelength plate 123A is an element for changing a polarization state of the laser light L in a case where the laser light L is directed from the polarization beam splitter 122 to the first optical element 121A and in a case where the laser light L is directed from the first optical element 121A to the polarization beam splitter 122 such that the optical path of the laser light L is changed by the polarization beam splitter 122. An example of the first wavelength plate 123A is a λ/4 plate.

The second wavelength plate 123B is disposed between the second optical element 121B and the polarization beam splitter 122. The second wavelength plate 123B is an element for changing the polarization state of the laser light L in a case where the laser light L is directed from the polarization beam splitter 122 to the second optical element 121B and in a case where the laser light L is directed from the second optical element 121B to the polarization beam splitter 122 such that the optical path of the laser light L is changed by the polarization beam splitter 122. An example of the second wavelength plate 123B is a λ/4 plate.

The plurality of element sets 120 are disposed such that the first total reflection mirror 112A, the plurality of polarization beam splitters 122, and the output mirror 111 are arranged along the first direction X.

In the laser system 100C, the dielectric multilayer films 12 included in the first optical element 121A and the second optical element 121B, the first total reflection mirror 112A, and the output mirror 111 configure an optical resonator 101C. Since the plurality of polarization beam splitters 122, the plurality of first wavelength plates 123A, and the plurality of second wavelength plates also affect the optical path of the laser light L, they may also be a part of the optical resonator 101.

In the laser system 100C, the first optical element 121A and the second optical element 121B are the optical elements 10. Therefore, the laser system 100C has the same operation and effect as those of the laser system 100. Since the laser system 100C includes the first optical element 121A and the second optical element 121B, the laser system includes a plurality of optical elements 10. As described above, the operation and effect accompanied by the laser system 100C including the plurality of optical elements 10 are similar to those of the laser system 100B.

The laser system 100C may include the Q switch element 104 as in the case of the laser system 100, the laser system 100A, and the laser system 100B. The Q switch element 104 can be disposed, for example, between the polarization beam splitter 122 located in a front stage of the output mirror 111 (closest to the output mirror 111) and the output mirror 111. The laser system 100C may include the mode lock element or the wavelength conversion element instead of the Q switch element 104. In a case where the laser system 100C includes a wavelength conversion element, the output mirror 111 may have a wavelength separation function similarly to the case of the laser system 100 and the like.

The laser system 100C may also include the light source unit 103 that outputs the excitation light 102.

### (Fifth Embodiment)

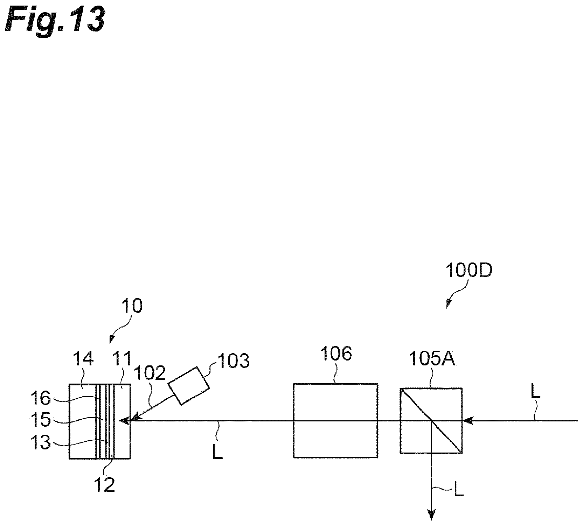

FIG. 13 is a schematic view illustrating another example of a laser system using an optical element. A laser system 100D illustrated in FIG. 13 is a laser amplifier. The laser system 100D has the optical element 10, a first polarization beam splitter 105A, and a Faraday element 106.

The optical element 10 is disposed such that the laser medium 11 faces the first polarization beam splitter 105A.

The Faraday element 106 is disposed between the optical element 10 and the first polarization beam splitter 105A. An example of the Faraday element 106 is a Faraday rotator. The Faraday element 106 controls the polarization state of the laser light L such that the amplified laser light L is reflected by the first polarization beam splitter 105A and output from the laser system 100D.

When the laser system 100D amplifies the laser light L, the optical element 10 is irradiated with the excitation light 102 to bring the laser medium 11 into an excited state. In this state, the laser light L for input is incident on the first polarization beam splitter 105A from the side opposite to the optical element 10. The laser light L passes through the first polarization beam splitter 105A and the Faraday element 106 and enters the optical element 10. The incidence of the laser light L causes stimulated emission in the laser medium 11, and the laser light L is amplified. The amplified laser light L is totally reflected by the dielectric multilayer film 12, passes through the Faraday element 106, and enters the first polarization beam splitter 105A. The laser light L changes its polarization state when passing through the Faraday element 106 from the optical element 10 toward the first polarization beam splitter 105A. As a result, the amplified laser light L is reflected by the first polarization beam splitter 105A and output from the laser system 100D.

The laser system 100D may include the light source unit 103 as in the case of the laser system 100.

The laser system 100D includes the optical element 10. Therefore, even when the laser system 100D generates high-output laser light L by amplifying the input laser light L, the laser system 100D is hardly damaged. Therefore, the laser system 100D can be stably used. Therefore, the optical element 10 can be effectively applied to the laser system 100D.

### (Sixth Modification)

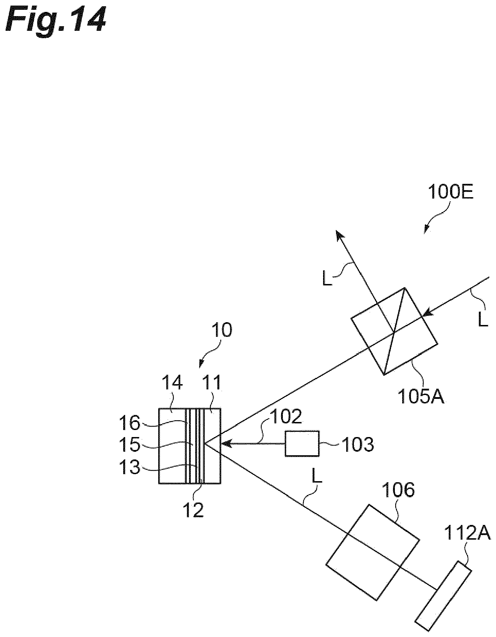

FIG. 14 is a schematic view illustrating another example of a laser system as a laser amplifier. A laser system 100E is mainly different from the laser system 100D in that it has a first total reflection mirror 112A.

The first total reflection mirror 112A is disposed on the same side as the first polarization beam splitter 105A with respect to the optical element 10 (more specifically, with respect to the laser medium 11). The first total reflection mirror 112A is disposed with respect to the optical element 10 such that an optical path of the laser light L between the first polarization beam splitter 105A and the optical element 10 is different from an optical path of the laser light L between the optical element 10 and the first total reflection mirror 112A.

The Faraday element 106 is disposed between the optical element 10 and the first total reflection mirror 112A. The Faraday element 106 may be disposed between the optical element 10 and the first polarization beam splitter 105A.

The laser system 100E has the same configuration as the laser system 100D except that the optical path of the laser light L accompanying the provision of the first total reflection mirror 112A is different from that of the laser system 100D. Therefore, the laser system 100E has the same operation and effect as those of the laser system 100D.

The laser system 100E may include the light source unit 103 as in the case of the laser system 100.

### (Sixth Embodiment)

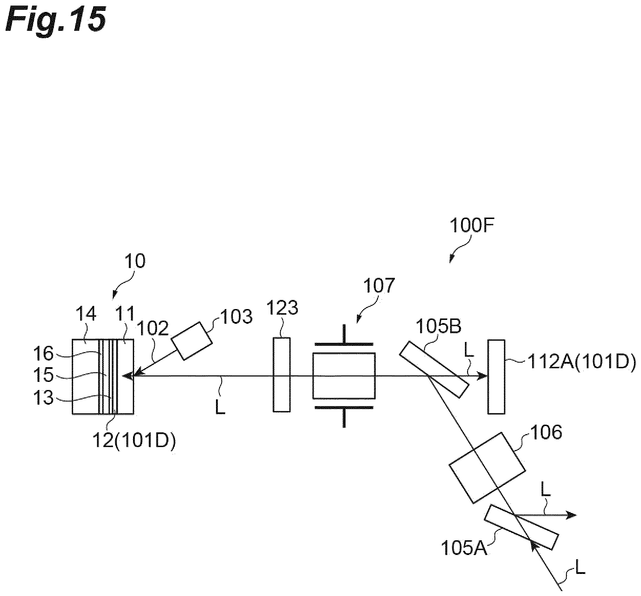

FIG. 15 is a schematic view of another example of a laser system using an optical element. A laser system 100F illustrated in FIG. 15 is a laser regeneration amplifier. The laser system 100F has the optical element 10, the first total reflection mirror 112A, the first polarization beam splitter 105A, an electrooptical element 107, a second polarization beam splitter 105B, and the Faraday element 106.

The optical element 10 is disposed such that the laser medium 11 faces the first total reflection mirror 112A. The second polarization beam splitter 105B and the electrooptical element 107 are disposed between the first total reflection mirror 112A and the optical element 10. The second polarization beam splitter 105B and the electrooptical element 107 are disposed in this order from the first total reflection mirror 112A toward the optical element 10. That is, the optical element 10, the electrooptical element 107, the second polarization beam splitter 105B, and the first total reflection mirror 112A are disposed in this order along one direction.

The first polarization beam splitter 105A and the Faraday element 106 are disposed in the order of the Faraday element 106 and the first polarization beam splitter 105A with respect to the second polarization beam splitter 105B. That is, the second polarization beam splitter 105B, the Faraday element 106, and the first polarization beam splitter 105A are disposed in this order along one direction.

A direction in which the optical element 10, the electrooptical element 107, the second polarization beam splitter 105B, and the first total reflection mirror 112A are disposed is different from a direction in which the second polarization beam splitter 105B, the Faraday element 106, and the first polarization beam splitter 105A are disposed.

In the configuration of the laser system 100F, the first total reflection mirror 112A and the dielectric multilayer film 12 included in the optical element 10 configure an optical resonator 101D. The laser light L is amplified by repeating propagation of the laser light L in the optical resonator 101D.

The electrooptical element 107 functions as an optical switch for extracting the laser light L propagating in the optical resonator 101D to the Faraday element 106 and the first polarization beam splitter 105A side via the second polarization beam splitter 105B. An example of the electrooptical element 107 is a Pockels cell.

In the laser system 100F, the laser light L is amplified while reciprocating a plurality of times in the optical resonator 101D. The laser light L thus amplified is output to the outside of the laser system 100F via the second polarization beam splitter 105B, the Faraday element 106, and the first polarization beam splitter 105A by controlling the electrooptical element 107.

In the laser system 100F, since the laser light L is amplified while reciprocating a plurality of times in the optical resonator 101D, the laser light L having higher output can be output. Even in such a case, since the optical element 10 is less likely to be damaged with respect to the high-output laser light L, the laser system 100F can stably output the high-output laser light L. Therefore, the optical element 10 can be more effectively applied to the laser system 100F.

As illustrated in FIG. 15, the laser system 100F may include a wavelength plate 123 that contributes to extraction of the laser light L from the optical resonator 101D together with the electrooptical element 107, between the electrooptical element 107 and the optical element 10. An example of the wavelength plate 123 is a λ/4 plate.

The laser system 100F may include the light source unit 103 that outputs the excitation light 102 as in the case of the laser system 100.

### (Seventh Modification)

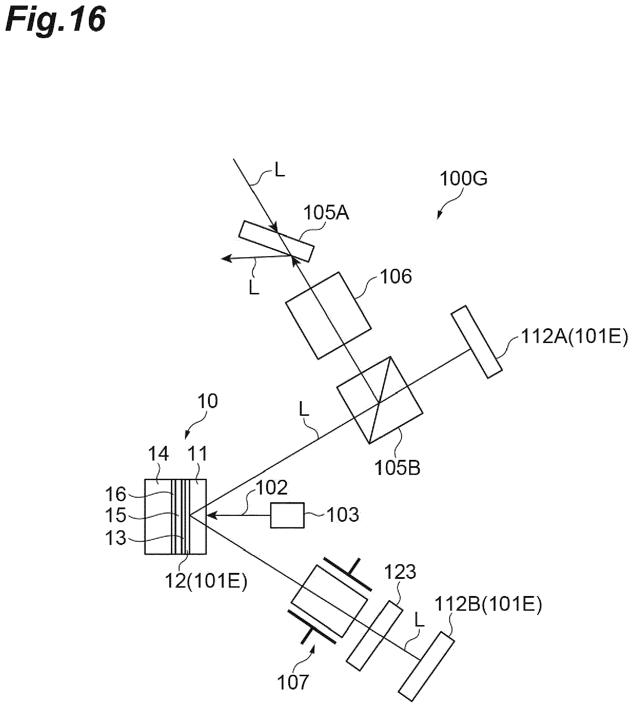

FIG. 16 is a schematic view illustrating another example of a laser system as a laser regeneration amplifier. A laser system 100G is mainly different from the laser system 100F in that it further has a second total reflection mirror 112B.

The second total reflection mirror 112B is disposed on the same side as the second polarization beam splitter 105B with respect to the optical element 10 (more specifically, with respect to the laser medium 11). The second total reflection mirror 112B is disposed with respect to the optical element 10 such that an optical path of the laser light L between the second polarization beam splitter 105B and the optical element 10 is different from an optical path of the laser light L between the optical element 10 and the second total reflection mirror 112B.

In the laser system 100G, an optical resonator 101E is formed by the first total reflection mirror 112A, the dielectric multilayer film 12 of the optical element 10, and the second total reflection mirror 112B.

The electrooptical element 107 is disposed between the second polarization beam splitter 105B and the second total reflection mirror 112B. In the example illustrated in FIG. 16, the electrooptical element 107 is disposed between the optical element 10 and the second total reflection mirror 112B. The electrooptical element 107 functions as an optical switch for extracting the laser light L propagating in the optical resonator 101E to the Faraday element 106 and the first polarization beam splitter 105A side via the second polarization beam splitter 105B.

The laser system 100G has the same configuration as the laser system 100F except that the optical path of the laser light L accompanying the provision of the second total reflection mirror 112B is different from that of the laser system 100F. Therefore, the laser system 100G has the same operation and effect as those of the laser system 100F.

The laser system 100G may include the light source unit 103 that outputs the excitation light 102 as in the case of the laser system 100. As in the case of the laser system 100F illustrated in FIG. 15, the laser system 100G may include the wavelength plate 123 that contributes to extraction of the laser light L from the optical resonator 101E. An example of the wavelength plate 123 is a λ/4 plate. The wavelength plate 123 is disposed between the electrooptical element 107 and the second total reflection mirror 112B.

### (Eighth Modification)

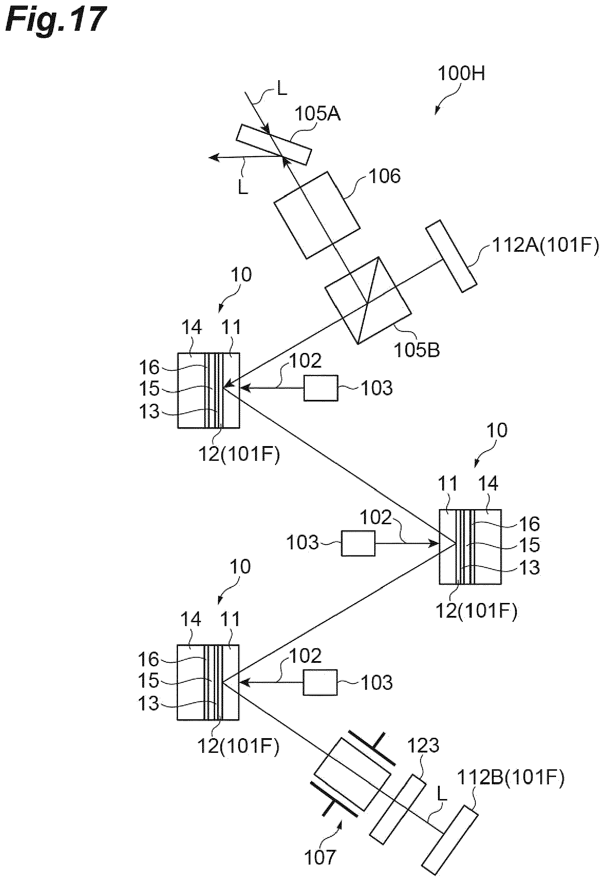

FIG. 17 is a schematic view illustrating another example of a laser system that is a laser regeneration amplifier. A laser system 100H illustrated in FIG. 17 is different from the laser system 100G mainly in that a plurality of optical elements 10 are provided between the first total reflection mirror 112A and the second total reflection mirror 112B. The laser system 100H is a multistage type laser regeneration amplifier.

In the laser system 100H, since the plurality of optical elements 10 are disposed on the optical path between the first total reflection mirror 112A and the second total reflection mirror 112B, the optical path between the first total reflection mirror 112A and the second total reflection mirror 112B is bent a plurality of times.

In the laser system 100H, the first total reflection mirror 112A, the dielectric multilayer films 12 included in the plurality of optical elements 10, and the second total reflection mirror 112B configure an optical resonator 101F.

The electrooptical element 107 is disposed on the optical path between the second polarization beam splitter 105B and the second total reflection mirror 112B. In the aspect illustrated in FIG. 17, the electrooptical element 107 is disposed between the second total reflection mirror 112B and an optical element 10 closest to the second total reflection mirror 112B in the optical path of the laser light L. The electrooptical element 107 functions as an optical switch for extracting the laser light L propagating in the optical resonator 101F to the Faraday element 106 and the first polarization beam splitter 105A side via the second polarization beam splitter 105B.

Since the laser system 100H also includes the optical element 10, the same operation and effect as those of the laser system 100G are obtained. Since the laser system 100H includes the plurality of optical elements 10, the laser light L can be further amplified. Even in such a case, since the optical element 10 is less likely to be damaged with respect to the high-output laser light L, the laser system 100H can stably output the high-output laser light L. Therefore, the optical element 10 can be more effectively applied to the laser system 100H.

The laser system 100H may include the light source unit 103 that outputs the excitation light 102 as in the case of the laser system 100. As in the case of the laser system 100F illustrated in FIG. 15, the laser system 100H may include the wavelength plate 123 that contributes to extraction of the laser light L from the optical resonator 101F. An example of the wavelength plate 123 is a λ/4 plate. The wavelength plate 123 is disposed between the electrooptical element 107 and the second total reflection mirror 112B.

### (Ninth Modification)

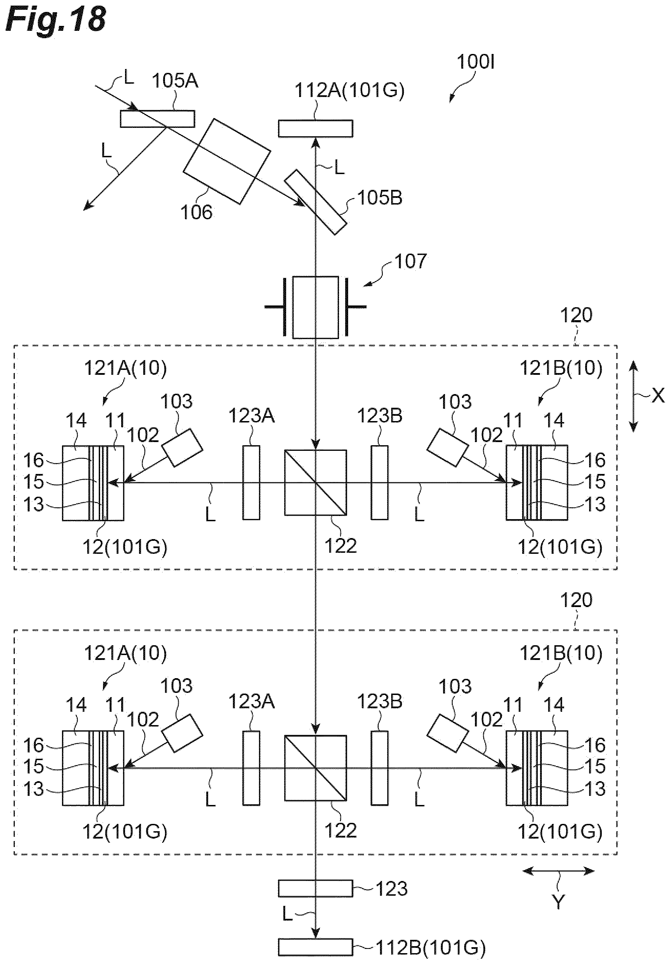

FIG. 18 is a schematic view illustrating another example of a laser system that is a laser regeneration amplifier. A laser system 100I is different from the laser system 100G in that it has a plurality of element sets 120 between the first total reflection mirror 112A and the second total reflection mirror 112B. Also in the description of the ninth modification, the first direction X and the second direction Y set in the fifth modification are used.

In the laser system 100I, the first total reflection mirror 112A, the second polarization beam splitter 105B, the plurality of element sets 120, and the second total reflection mirror 112B are disposed along the first direction X.

The configuration of the plurality of element sets 120 is the same as the configuration of the element set 120 described with reference to FIG. 12. That is, the element set 120 includes the first optical element 121A, the second optical element 121B, the polarization beam splitter 122, the first wavelength plate 123A, and the second wavelength plate 123B.

Each of the first optical element 121A and the second optical element 121B is the same element as the optical element 10. The first optical element 121A and the second optical element 121B are separated in a direction (in FIG. 18, a direction orthogonal to the first direction X) crossing the first direction X, and are disposed such that the laser media 11 included in the first optical element 121A and the second optical element 121B face each other.

The polarization beam splitter 122 is disposed between the first optical element 121A and the second optical element 121B.

The first wavelength plate 123A is disposed between the first optical element 121A and the polarization beam splitter 122. The first wavelength plate 123A is an element for changing a polarization state of the laser light L in a case where the laser light L is directed from the polarization beam splitter 122 to the first optical element 121A and in a case where the laser light L is directed from the first optical element 121A to the polarization beam splitter 122 such that the optical path of the laser light L is changed by the polarization beam splitter 122. An example of the first wavelength plate 123A is a λ/4 plate.

The second wavelength plate 123B is disposed between the second optical element 121B and the polarization beam splitter 122. The second wavelength plate 123B is an element for changing the polarization state of the laser light L in a case where the laser light L is directed from the polarization beam splitter 122 to the second optical element 121B and in a case where the laser light L is directed from the second optical element 121B to the polarization beam splitter 122 such that the optical path of the laser light L is changed by the polarization beam splitter 122. An example of the second wavelength plate 123B is a λ/4 plate.

The plurality of element sets 120 are disposed such that the first total reflection mirror 112A, the plurality of polarization beam splitters 122, and the second total reflection mirror 112B are arranged along the first direction X.

In the laser system 100I, the first total reflection mirror 112A, the dielectric multilayer films 12 of the first optical element 121A and the second optical element 121B, and the second total reflection mirror 112B configure an optical resonator 101G. Since the plurality of polarization beam splitters 122, the plurality of first wavelength plates 123A, and the plurality of second wavelength plates 123B also affect the optical path of the laser light L, they may also be a part of the optical resonator 101G.

The electrooptical element 107 is disposed between the second polarization beam splitter 105B and the second total reflection mirror 112B in the first direction X. In the example illustrated in FIG. 18, the electrooptical element 107 is disposed between the second polarization beam splitter 105B and an element set 120 closest to the second polarization beam splitter 105B among the plurality of element sets 120. The electrooptical element 107 functions as an optical switch for extracting the laser light L propagating in the optical resonator 101G to the Faraday element 106 and the first polarization beam splitter 105A side via the second polarization beam splitter 105B.

The laser system 100I includes the first optical element 121A and the second optical element 121B which are the optical elements 10. That is, the laser system 101I includes a plurality of optical elements 10. Therefore, the laser device 100I has the same operation and effect as those of the laser system 100H.

The laser system 100I may include the light source unit 103 that outputs the excitation light 102 as in the case of the laser system 100. As in the case of the laser system 100F illustrated in FIG. 15, the laser system 100I may include the wavelength plate 123 that contributes to extraction of the laser light L from the optical resonator 101G. An example of the wavelength plate 123 is a λ/4 plate. The wavelength plate 123 is disposed outside the element set 120 between the electrooptical element 107 and the second total reflection mirror 112B. In FIG. 18, the wavelength plate 123 is disposed between the polarization beam splitter 122 of an element set 120 closest to the second total reflection mirror 112B among the plurality of element sets 120 and the second total reflection mirror 112B.

The present invention is not limited to the various exemplified embodiments, but is intended to include the scope indicated by the claims and to include all modifications within the meaning and scope equivalent to the claims.

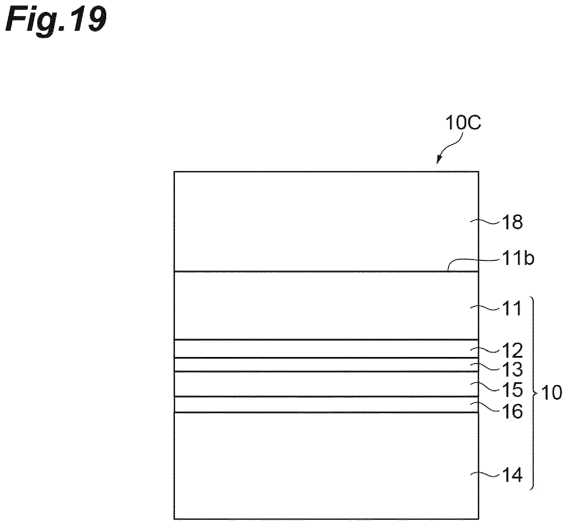

The optical element may have a parasitic oscillation prevention unit 18 on the second surface 11b of the laser medium 11 as in an optical element 10C illustrated in FIG. 19. The optical element 10C corresponds to an element including the optical element 10 and the parasitic oscillation prevention unit 18 provided on the optical element 10. The optical element 10C may include the optical element 10A or the optical element 10B instead of the optical element 10. The parasitic oscillation prevention unit 18 is a transparent body with respect to the laser light L and the excitation light 102. Examples of a material of the parasitic oscillation prevention unit 18 include a non-doped laser material (for example, YAG), sapphire (Al₂O₃), and the like. In one embodiment, the material of the laser medium 11 is Yb-doped YAG (Yb:YAG), and the material of the parasitic oscillation prevention unit 18 is YAG or Al₂O₃. By providing the parasitic oscillation prevention unit 18, the generated parasitic oscillation light escapes to a region of the parasitic oscillation prevention unit 18 having no gain, such that amplification can be suppressed, and parasitic oscillation can be prevented. The dielectric multilayer film 17 (see FIG. 1) for preventing parasitic oscillation may be formed on the surface of the parasitic oscillation prevention unit 18 (the surface opposite to the laser medium 11).

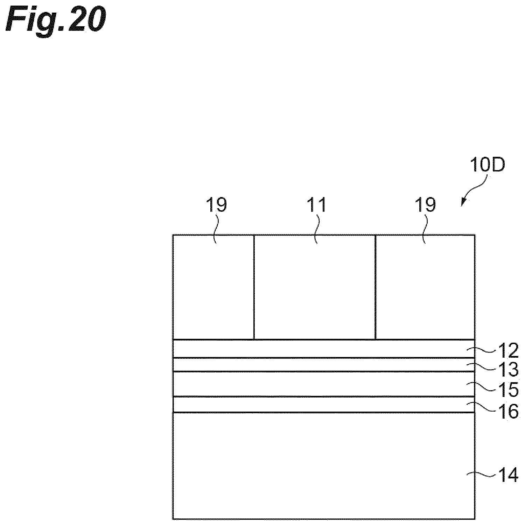

As in an optical element 10D illustrated in FIG. 20, the optical element may have an absorption unit 19 for preventing parasitic oscillation on a side surface of the laser medium 11. In this case, the dielectric multilayer film 12 and the like are disposed on the layer configured by the laser medium 11 and the absorption unit 19. An example of a material of the absorption unit 19 is, for example, YAG (Cr:YAG or Sm:YAG) doped with Cr or Sm or a garnet material to which Cr or Sm is added for laser oscillation with a wavelength of 1 µm. In one embodiment, the material of the laser medium 11 is Yb: YAG, and the material of the absorption unit 19 is Cr:YAG. The material of the absorption unit 19 may be Nd:YAG, or may be another material to which Yb or Nd is added. Examples of the material of the absorption unit 19 include vanadium-doped YAG (V:YAG) for a wavelength of 1.3 µm, and Co spinel for a wavelength of 1.5 µm. In the aspect including the absorption unit 19, the generated parasitic oscillation light is absorbed by the absorption unit 19 (for example, Cr:YAG). As described above, since the parasitic oscillation light can be eliminated by the absorption unit 19, the parasitic oscillation can be prevented. A dielectric multilayer film as an antireflection film may be formed on a surface opposite to the dielectric multilayer film 12 in the layer configured by the laser medium 11 and the absorption unit 19.

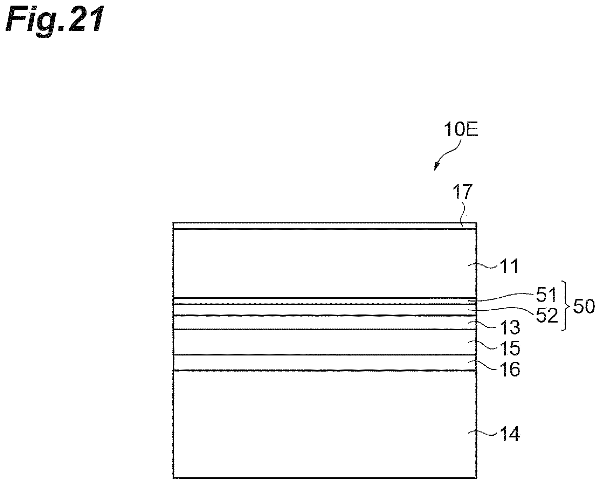

In the description so far, the first intermediate layer included in the optical element is the dielectric multilayer film 12. However, the first intermediate layer may be an intermediate layer 50 illustrated in FIG. 21. FIG. 21 is a schematic view illustrating an optical element 10E including the intermediate layer 50. The optical element 10E is different from the optical element 10 in that it has the intermediate layer (first intermediate layer) 50 instead of the dielectric multilayer film 12, and the other configuration is similar to that of the optical element 10.

The intermediate layer 50 has a dielectric multilayer film 51 formed on the laser medium 11 and a nonmetallic heat transfer layer 52 formed on the dielectric multilayer film 51.

The dielectric multilayer film 51 totally reflects the laser light L generated or amplified by the stimulated emission of the laser medium 11. In one embodiment, the dielectric multilayer film 51 functions as an HR coating layer with respect to the laser light L. The material of the dielectric multilayer film 51 may be the same as that of the dielectric multilayer film 12.

An example of a material of the nonmetallic heat transfer layer 52 is a nonmetallic material having high thermal conductivity. The nonmetallic heat transfer layer 52 may be formed of, for example, diamond, silicon carbide (SiC), or nitride. An example of the nitride is aluminum nitride (AIN). The nonmetallic heat transfer layer 52 can function as a heat spreader.

The intermediate layer 50 has a thickness such that the evanescent wave EW (see FIG. 1) generated when laser light generated or amplified by the laser medium 11 is totally reflected by the dielectric multilayer film 51 does not reach the first metal layer 13. In other words, the thickness of the intermediate layer 50 is longer than the protrusion length of the evanescent wave EW, and may have a thickness similar to that of the dielectric multilayer film 12 illustrated in FIG. 1. Since the intermediate layer 50 having the above thickness has the dielectric multilayer film 51 and the nonmetallic heat transfer layer 52, the thickness of the dielectric multilayer film 51 may be thinner than the thickness of the dielectric multilayer film 12. The nonmetallic heat transfer layer 52 can be a layer for adjusting the thickness of the intermediate layer 50. The thickness of the intermediate layer 50 may be thicker than that of the dielectric multilayer film 12.

The optical element 10E can be manufactured in the same manner as the method for manufacturing the optical element 10 except that the first component having the intermediate layer 50 is used instead of the dielectric multilayer film 12 in the first component 20. The first component having the intermediate layer 50 can be prepared, for example, by performing a step of forming the dielectric multilayer film 51 on the laser medium 11 and a step of forming the nonmetallic heat transfer layer 52 on the dielectric multilayer film 51. The nonmetallic heat transfer layer 52 may be provided on the dielectric multilayer film 51 by joining a heat transfer body formed of the diamond or the like exemplified to the dielectric multilayer film 51.

Similarly to the dielectric multilayer film 12, the intermediate layer 50 has a thickness such that the evanescent wave EW (see FIG. 1) described above does not reach the first metal layer 13. Therefore, the intermediate layer 50 and the optical element 10E including the intermediate layer have the same operations and effects as those of the optical element 10. The nonmetallic heat transfer layer 52 included in the intermediate layer 50 can function as a heat spreader. Therefore, since the heat generated in the laser medium 11 is diffused also in an in-plane direction, the heat is easily dissipated, and a local temperature rise hardly occurs, such that the optical element 10E is less likely to be damaged.

Also in the optical element 10A, the optical element 10B, the optical element 10C, and the optical element 10D, the intermediate layer 50 can be adopted instead of the dielectric multilayer film 12.

In the laser systems described with reference to FIGS. 13, 14, 15, 16, 17, and 18, the Faraday element 106 is used as an optical path control element for extracting the laser light L. However, a known other element that is used in a laser amplifier (including a laser regeneration amplifier) and can realize a similar function may be used. For example, a wavelength plate (for example, a λ/4 plate) may be adopted instead of the Faraday element.

In the laser systems (laser regeneration amplifiers) described with reference to FIGS. 15, 16, 17, and 18, the electrooptical element is used as an optical switch element (or an optical path control element) for extracting laser light from the optical resonator. However, other known elements that are used in the laser regeneration amplifier and can realize similar functions may be used.

The number of stages of the multistage medium type laser oscillator in the fourth modification and the fifth modification is not limited to the number of stages illustrated in FIGS. 11 and 12. It is sufficient that the number of stages in the multistage medium type laser oscillator is two or more. Similarly, the number of stages of the multistage type laser regeneration amplifier in the eighth modification and the ninth modification is not limited to the number of stages illustrated in FIGS. 17 and 18. It is sufficient that the number of stages in the multistage type laser regeneration amplifier is two or more.

The various embodiments, modifications, and the like described above may be appropriately combined without departing from the gist of the invention.

### Reference Signs List

10, 10A, 10B, 10C, 10D, 10E Optical element
11 Laser medium
11a First surface
11b Second surface
12 Dielectric multilayer film (first intermediate layer)
12a First surface
13 First metal layer
13a First surface
14 Heat sink
14a First surface
15 Intermediate layer (second intermediate layer)
15a First surface
16 Second metal layer
16a First surface
16a Second surface
17 Dielectric multilayer film
18 Parasitic oscillation prevention unit
19 Absorption unit
20, 20A, 20B, 20C First component
20a Joint surface
30, 30A, 30B Second component
30a Joint surface
40 Chamber
41 Beam source
42 Surface active beam
50 Intermediate layer (first intermediate layer)
51 Dielectric multilayer film
52 Nonmetallic heat transfer layer
100, 100A, 100B, 100C, 100D, 100E, 100F, 100G, 100H, 100I Laser system
101, 101A, 101B, 101C, 101D, 101E, 101F, 101G Optical resonator
102 Excitation light
103 Light source unit
104 Q switch element
105A First polarization beam splitter
105B Second polarization beam splitter
106 Faraday element
107 Electrooptical element
111 Output mirror
112A First total reflection mirror
112B Second total reflection mirror
120 Element set
X First direction
121A First optical element
121B Second optical element
122 Polarization beam splitter
123 Wavelength plate
123A First wavelength plate
123B Second wavelength plate
151 Intermediate layer
151a First surface
152 Intermediate layer
152a First surface
L Laser light
EW Evanescent wave

## Claims

1. An optical element comprising:
a laser medium;
a first intermediate layer provided on the laser medium;
a first metal layer formed on the first intermediate layer and including a Group 4 element or a Group 6 element; and
a heat sink provided on the first metal layer and including a metal, wherein
the first intermediate layer includes a dielectric multilayer film that is formed on the laser medium and totally reflects laser light generated or amplified by the laser medium, and
the first intermediate layer is thicker than a protrusion length of an evanescent wave generated by reflection of light incident from the laser medium side by the dielectric multilayer film.

2. The optical element according to claim 1, further comprising:
a second metal layer disposed between the first metal layer and the heat sink and including a Group 10 element.

3. The optical element according to claim 2, wherein
a material of the second metal layer is nickel or platinum.

4. The optical element according to claim 2 or 3, further comprising:
a second intermediate layer disposed between the first metal layer and the second metal layer, wherein
a material of the intermediate layer is gold or a gold alloy.

5. The optical element according to any one of claims 1 to 4, wherein
a material of the first metal layer is chromium or titanium.

6. The optical element according to any one of claims 1 to 5, wherein
a material of the heat sink is copper, copper tungsten, copper molybdenum, iron, aluminum, or an aluminum-silicon carbide composite.

7. The optical element according to any one of claims 1 to 6, wherein
the first intermediate layer has
the dielectric multilayer film, and
a nonmetallic heat transfer layer disposed between the dielectric multilayer film and the first metal layer.

8. The optical element according to claim 7, wherein
a material of the nonmetallic heat transfer layer is diamond, silicon carbide, or nitride.

9. A laser system comprising:
the optical element according to any one of claims 1 to 7.

10. A method for manufacturing an optical element, the method comprising:
a preparation step of preparing a first component including a laser medium and a second component including a heat sink including a metal; and
a joining step of joining the first component and the second component, wherein
the preparation step has
a step of forming a first intermediate layer on the laser medium, and
a step of forming a first metal layer including a Group 4 element or a Group 6 element on the first intermediate layer,
in the joining step, the first component and the second component are joined via the first metal layer,
the first intermediate layer includes a dielectric multilayer film that is formed on the laser medium and totally reflects laser light generated or amplified by the laser medium, and
in the step of forming the first intermediate layer, the first intermediate layer is formed such that a thickness of the first intermediate layer is thicker than a protrusion length of an evanescent wave generated by reflection of light incident from the laser medium side by the dielectric multilayer film.

11. The method for manufacturing an optical element according to claim 10, wherein
the preparation step has a step of forming a second metal layer including a Group 10 element on the heat sink, and
in the joining step, the first component and the second component are joined via the first metal layer and the second metal layer.

12. The method for manufacturing an optical element according to claim 11, wherein
the preparation step has a step of forming a layer to be a second intermediate layer disposed between the first metal layer and the second metal layer on at least one of the first metal layer and the second metal layer.

13. The method for manufacturing an optical element according to any one of claims 10 to 12, wherein
in the joining step, after a surface of the first component on a side to be joined to the second component and a surface of the second component on a side to be joined to the first component are subjected to a surface activation treatment, the first component and the second component subjected to the surface activation treatment are joined.

14. The method for manufacturing an optical element according to claim 10, further comprising:
a step of subjecting a surface of the first component on a side to be joined to the second component and a surface of the second component on a side to be joined to the first component to a surface activation treatment, wherein
the preparation step further has a step of forming a second metal layer including a Group 10 element on the first metal layer,
the second component is the heat sink, and
in the joining step, the first component and the second component are joined via the second metal layer.

15. The method for manufacturing an optical element according to any one of claims 10 to 14, wherein
the step of forming the first intermediate layer has
a step of forming the dielectric multilayer film on the laser medium, and
a step of forming a nonmetallic heat transfer layer on the dielectric multilayer film.
